# EUROPEAN PATENT SPECIFICATION

(11) **EP 0 319 038 B1**
(45) Date of publication and mention of the grant of the patent: **13.07.1994**
(21) Application number: 88120173.5
(22) Date of filing: 02.12.1988
(51) Int. Cl.: H01L 41/04

(54) **Sealing structure of an electrostrictive element**
Struktur zur Versiegelung eines elektrostriktiven Elements
Structure pour sceller un élément électrostrictif

(30) Priority: 02.12.1987 JP 306543/87; 04.11.1988 JP 279773/88
(43) Date of publication of application: 07.06.1989
(73) Proprietor: NEC CORPORATION, Tokyo (JP)
(72) Inventor: Nishizawa, Takeshi c/o NEC Corporation, Minato-ku Tokyo (JP)
(74) Representative: Pätzold, Herbert, Dr.-Ing.

(56) References cited:
- US-A- 4 553 059
- PATENT ABSTRACTS OF JAPAN vol. 9, no. 288 (E-358)(2011) 15 November 1985 ; & JP-A-60 128 874

## Description

### BACKGROUND OF THE INVENTION:

This invention relates to a sealing structure of an electrostrictive element as mentioned in the introduction part of claim 1, which is known from the US-A-4570095
Piezoelectric actuators have been regarded as a promising mechanical driving element for optical or magnetic disc heads, various optical devices and precision positioning devices for precision tool machines. Since the mechanical displacement caused by electrostrictive effect is essentially very small, the rectangular piezoelectric effect is usually increased by stacking a plurality of electrostrictive ceramic layers or piezoelectric ceramic layers with internal electrodes as is disclosed in the U.S. Patent No. 4,681,667 issued on July 21, 1987. The mechanical displacement may be further increased by using a mechanical amplification mechanism as is disclosed in the U.S. Patent No. 4,570,095 issued on February 11, 1986.

In a conventional electrostrictive element using silver based internal electrodes, migration easily takes place at exposed ends of the internal electrodes in a humid atmosphere, and thus causing a poor insulation characteristics. When moisture resistance tests are conducted, discharge occurs at sides or corners of the electrostrictive element to present serious problems in yielding and reliability. There has been proposed a measurement to coat the electrostrictive element with an insulation resin so as to prevent moisture from entering, but the moisture resistance achieved is not quite satisfactory. In addition, the mechanical displacement of expantion and contraction of the electrostrictive element is impaired by the resin coated on the side surface of the electrostrictive element.

JP-A-60 128 874 discloses an electrostrictive device comprising a tubular member, an electrostrictive element located within said tabular member, a first lid member attached to one end of said electrostrictive element, and a second, lid member attached to the other end of said electrostrictive element which has a pair of electrode terminals connected to said electrostrictive element. The first lid member consists of a piston which is displaced within the tubular member. The length of the tubular member ist larger than the height of said electrostrictive element but shorter than the sum of said electrostrictive element attached with said first and second lid members

### SUMMARY OF THE INVENTION:

An object of this invention is to provide a sealing structure of an electrostrictive element as mentioned above which can prevent moisture from entering from outside and remarkably enhance reliability of the electrostrictive element without impairing the mechanical displacement of the electrostrictive element.

In accordance with the present invention said object is obtained with the features of the characterized part of claim 1. Preferred embodiments of the invention are mentioned in the depending claims.

According to this invention, the sealing structure of the electrostrictive element has a pair of lid members mounted on both ends of the electrostrictive element. The electrostrictive element is inserted within a tubular member such that the side surfaces of the lid members are partially covered with the end portion of the tubular member and connected to each other to form flexible sealing joint portions for instance elastic resin or an O-ring between gaps formed between the tubular member 14 and the first and second lid members 11 and 13 so as to prevent moisture from entering into the tubular member from outside while allowing a small displacement in a direction of the tubular axis. One of lid members has a pair of lead terminals which are connected to external electrodes of the electrostrictive element via lead wires. It is preferable that the tubular member and the lid members are made of metal to enhance the reliability, and elastic sealing material is used to combine the metal tube and the metal lids so as to ease the mechanical displacement of the electrostrictive element.

It is advantageous if the tubular member is housing said electrostrictive element according to this invention whereby insulation liquid is filled within the tubular member.

### BRIEF DESCRIPTION OF THE DRAWINGS:

FIG. 1 shows a sectional view of the first embodiment according to this invention.

FIG. 2 shows a sectional view of the second embodiment according to this invention.

FIG. 3 shows a sectional view of the third embodiment according to this invention.

FIG. 4 shows a sectional view of the fourth embodiment according to this invention.

### DESCRIPTION OF THE PREFERRED EMBODIMENTS:

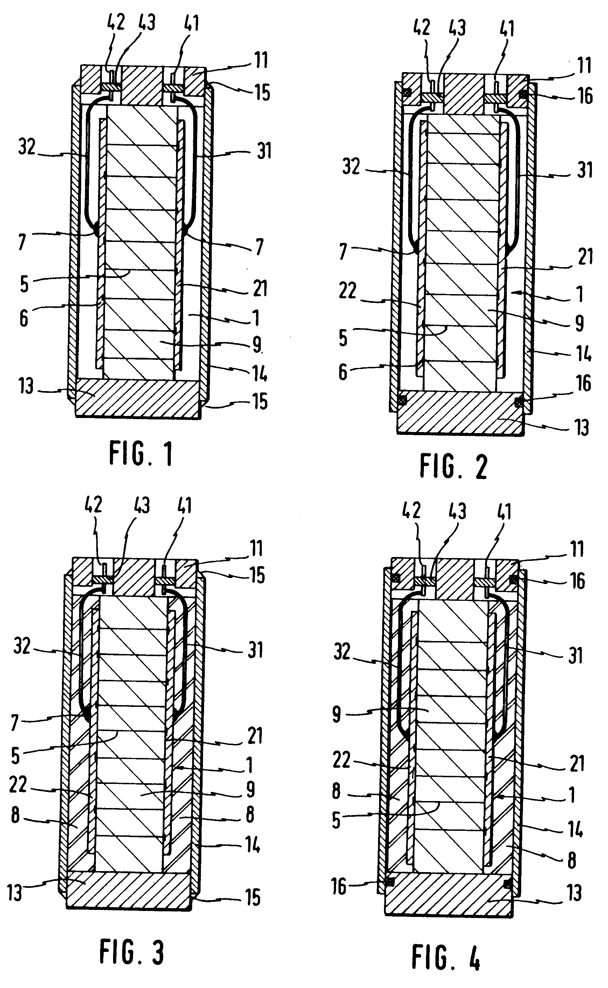

Referring to FIG. 1, an electrostrictive element assembly of this embodiment comprises an electrostrictive element 1 housed within a tubular member 14 and sealed with a first lid member or a terminal member 11 and a second lid member 13 by using elastic sealing resine 15. The terminal member 11 has lead terminals rods 41 and 42 connected to the electrostrictive element 1.

The electrostrictive element 1 in this embodiment is a sintered body which is described in the aforementioned U.S. Patent No. 4,681,667. Exposed ends of internal electrodes 5 on side faces of the electrostrictive element 1, are coated selectively with an inorganic insulator 6 such as glass. Then a pair of external electrodes 21 and 22 are formed on side faces thereof such that the internal electrodes 5 are alternately connected to the external electrodes 21 and 22 to form two group of comb-shaped electrode members. Subsequently, the lead wires 31 add 32 are connected to the external electrodes 21 and 22 by soldering 7, respectively. The electrostrictive element 1 is fixed to a terminal member 11 and a lid member 13 with adhesive material to be supported within the tubular member 14 as shown in FIG. 1. The terminal member 11 is a circular disc which has a pair of holes provided with lead terminal rods 41 and 42. The lead terminal rods 41 and 42 are supported by sealing glass 43 and then realed from the atmosphere. Each lead wires 31 and 32 are connected with ends of a lead terminal rods 41 and 42 by soldering, respectively. The terminal member 11 and the lid member 13 have the same diameter which is smaller than the internal diameter of the tubular member 14 but larger enough such that the electrostrictive element 1 is spaced apart from the inner wall of the tubular member 14. Further the diameters of the lid members 11 and 13 are such that side edges of them are slidably contacted with the inner wall of the tubular member 14 The terminal member 11 and the lid member 13 are flexibly and air-tightly combined to the tubular member 14 by using elastic sealing material such as silicone resin and epoxy resin for air-tightness. As shown in FIG. 1, the tubular member has a height larger than that of the electrostrictive element 1 but less than the total sum of the terminal member 11, the lid member and the electrostrictive element 1. The materials of the terminal member 11 and the lid member 13 are preferably metals, especially stainless steel. As the tubular member 14, a tube of stainless steel of 0.5 mm in thickness is used in this embodiment.

The electrostrictive element assembly thus prepared was tested for 1,000 hours at 40°C, and 90 - 95%RH, and applied with a DC voltage of 150 V. The test showed no adverse results.

When a voltage is applied via the lead terminal rods 41 and 42 from a voltage supply source (not shown) between the external electrodes 21 and 22, all the electrostrictive sheets 9 between internal electrodes are applied with voltage to generate electrostrictive strain in the element in a direction of axis of the tubular member 14. When the thickness of each electrostrictive sheet is 0.1 mm and stacked with 770 sheets, the displacement of about 0.1 mm can be obtained. For such a small displacement, the elastic resin can keep the air-tightness.

FIG. 2 shows another embodiment. This embodiment differs from the first embodiment in that an O-ring 16 is used as the elasting sealing means. The terminal member 11 and the lid member 13 are provided with grooves so that the O-ring 16 is flexibly attached to the members 11 and 13. The size of the grooves is determined such that the compression ratio of the O-ring 16 becomes 0.85 - 0.65. The O-ring 16 which is applied with silicone grease is fitted in each groove, and a stainless steel tube 14 of the thickness of 0.5 mm is forced in from one direction. Since the displacement of the electrostrictive element is so small, ordinary O-ring can afford to absorb such displacement without causing a slip or slide between the O-ring and the tubular member due to the fact that the value of the displacement of the electrostrictive element does not exceed the elastic displacement region of the rubber used for ordinary O-ring. Therefore, the air-tightness can be sustained.

The electrostrictive element assembly thus completed was tested under the same conditions as in the first embodiment, but no adverse result was observed.

FIG. 3 shows the third embodiment of this invention. The third embodiment differs from the first embodiment shown in FIG. 1 only in that insulation liquid 8 is filled within the tubular member 14. More specifically, on an end face of the electrostrictive element 1 is fixed a disc-shaped metal member 11 made of stainless steel which is provided with a pair of lead terminals 41 and 42 connected to the external electrodes 21 and 22 via lead wires 31 and 32, respectively. On the other end face of the electrostrictive element 1 is fixed a disc-shaped metal member 13 having the outer diameter identical to that of the metal member 11. The joint portions between the tubular member 14 and the metal members 11 and 13 are sealed by epoxy resin 15. The side faces of the electrostrictive element are spaced apart from the inner wall of the stainless steel tube 14 of 0.5 mm in thickness, and silicone oil 8 is filled within the tube 14.

The manufacturing method of the shown electrostrictive element is described below.

Similarly to the aforementioned U.S. Patent No. 4,681,667, multicomponent solid solution ceramic powder of a perovskite structure is mixed with an organic binder to prepare green-sheets of about 100 »m in thickness, which is coated with silver internal electrode conductive layers in paste form. After dried, thus coated sheets are stacked for lamination in several tens of layers (e.g. 72 layers) and sintered to obtain a sintered body. As ends of the silver internal electrode conductive layers are exposed on side faces of the sintered body, end faces are selectively coated with glass insulator. Thus, external electrodes are formed on side faces and connected to the silver internal electrodes alternately in every two layers to form two groups of comb-shaped internal electrode assembly. Lead wires are connected to the external electrodes by soldering for leading out. The electrostrictive element 1 thus made is sealed within the tube 14 with the silicone oil 8 after being attached with metal members 11 and 13.

The electrostrictive element thus prepared was tested under the same conditions as in the first embodiment, but no adverse result was observed.

FIG. 4 shows the fourth embodiment of the present invention. The fourth embodiment differs from the embodiment shown in FIG. 2 only in that silicone oil is filled within the tubular member 14. As other features and structures are the same with the one shown in FIG. 2, detailed description is omitted.

Although the silicone oil is used in the foregoing instance, the insulating liquid to be filled within the tube may be fluorocarbon-based oils or mineral oils.

As described in the foregoing statement, this invention can prevent moisture from entering from outside into an electrostrictive element without preventing the mechanical displacement caused by the electrostrictive element in the tube element. When the tubular member is filled with insulating liquid, the electrical reliability of the electrostrictive element is further improved.

## Claims

1. A sealing structure of an electrostrictive element (9) of a plurality of stacked electrostrictive sheets comprising :
(a) a tubular member (14) housing said electrostrictive element (9) such that the inner wall of said tubular member is spaced apart, from said electrostrictive element (9),
(b) a first lid member (13) fixed to one end of said electrostrictive element (9),
(c) a second lid member (11) fixed to the opposite end of said electrostrictive element (9) which has electrode terminals (41, 42) connected to said electostrictive element (9),
(d) said first and second lid members (13, 11) being flexibly and airtightly combined to said tubular member (14) by using sealing means of elastic resin,
**characterized in that**
(e) said electrostrictive element (9) is inserted within said tubular member (14) such that the side surfaces of said first and second lid members (13, 11) are partially covered with one of the end portions of said tubular member (14) respectively, wherein
(f) each of said first and second lid members (13, 11) consisting of a circular disc with a diameter smaller than the inner diameter of said tubular member (14) such that side edges of said first and second lid members (13, 11) are slidably contacted with the inner wall of said tubular member (14) and wherein
(g) said sealing means (15, 16) sealing gaps between the inner wall of said end portions of said tubular member (14) and said side edges of said first and second lid members (13, 11) respectively,
(h) the thickness and the number of said stacked sheets are selected such that the value of the displacement of said electrostrictive element (9) in a direction of the tubular axis does not exceed the elastic displacement region of the elastic resin of said sealing means (15, 16) absorbing such displacement without causing a slip or slide between said sealing means (15, 16) and said tubular member (14).

2. A sealing structure as claimed in claim 1 wherein said sealing means is an elastic resin (15) or an O-ring (16).

3. A sealing structure as claimed in claim 2, wherein said first and second lid members (13, 11) having a groove around their side edge portions of said lid members respectively, said groove having a depth smaller than the diameter of the cross section of said O-ring (16).

4. A sealing structure as claimed in claim 1 wherein said displacement of said electrostrictive element (9) is about 0,1 mm.

5. A sealing structure as claimed in claim 1, wherein said first and second lid members (13, 11) and the tubular member (14) are made of metal.

6. A sealing structure as claimed in at least one of the above-mentioned claims comprising insulative fluid (8) filled within said tubular member (14).

## Patentansprüche

1. Dichtungskonstruktion für ein Elektrostriktionselement (9) aus einer Vielzahl übereinandergestapelter Elektrostriktionslagen, welche folgendes aufweist:
(a) ein rohrförmiges Teil (14), in welchem das Elektrostriktionselement (9) in der Weise untergebracht ist, daß die Innenwandung des rohrförmigen Teils sich im Abstand von dem Elektrostriktionselement (9) befindet,
(b) ein an einem Ende des Elektrostriktionselements (9) befestigtes erstes Deckelteil (13),
(c) ein am entgegengesetzten Ende des Elektrostriktionselements (9) befestigtes zweites Deckelteil (11), welches Elektrodenanschlüsse (41, 42) aufweist, die mit dem Elektrostriktionselement (9) verbunden sind,
(d) wobei das erste und das zweite Deckelteil (13, 11) unter Verwendung einer Dichtungseinrichtung aus elastischem Kunstharz flexibel und luftdicht mit dem rohrförmigen Teil (14) verbunden sind,
**dadurch gekennzeichnet, daß**
(e) das Elektrostriktionselement (9) in der Weise in das rohrförmige Teil (14) eingesetzt ist, daß die Seitenflächen des ersten und zweiten Deckelteils (13, 11) jeweils teilweise durch einen der Endbereiche des rohrförmigen Teils (14) überdeckt sind, wobei
(f) das erste und zweite Deckelteil (13, 11) jeweils aus einer runden Scheibe bestehen, deren Durchmesser kleiner ist als der Innendurchmesser des rohrförmigen Teils (14), so daß Seitenkanten des ersten und zweiten Deckelteils (13, 11) in gleitender Berührung mit der Innenwandung des rohrförmigen Teils (14) stehen, und wobei
(g) die Dichtungseinrichtung (15, 16) jeweils Spalte zwischen der Innenwandung der Endbereiche des rohrförmigen Teils (14) und der jeweiligen Seitenkante des ersten und zweiten Deckelteils (13, 11) abdichtet,
(h) und wobei die Dicke und die Anzahl der übereinandergestapelten Lagen so gewählt sind, daß der Wert der Verschiebung des Elektrostriktionselements (9) in Richtung der Röhrenachse nicht über den Bereich der elastischen Verschiebung des elastischen Kunstharzes der Dichtungseinrichtung (15, 16) hinausgeht, welche diese Verlagerung aufnimmt, ohne ein Verrutschen oder Verschieben zwischen der Dichtungseinrichtung (15, 16) und dem rohrförmigen Teil (14) herbeizuführen.

2. Dichtungskonstruktion nach Anspruch 1, bei welcher die Dichtungseinrichtung ein elastisches Kunstharz (15) oder ein O-Ring (16) ist.

3. Dichtungskonstruktion nach Anspruch 3, bei welcher im ersten und zweiten Deckelteil (13, 11) jeweils eine Nut um deren seitliche Kantenbereiche vorgesehen ist, deren Tiefe kleiner ist als der Durchmesser des Querschnitts des O-Rings (16).

4. Dichtungskonstruktion nach Anspruch 1, bei welcher die Verschiebung des Elektostriktionselements (9) etwa 0,1 mm beträgt.

5. Dichtungskonstruktion nach Anspruch 1, bei welcher das erste und das zweite Deckelteil (13, 11) sowie das rohrförmige Teil (14) aus Metall bestehen.

6. Dichtungskonstruktion nach mindestens einem der vorhergehenden Ansprüche, welche eine in den Innenraum des rohrförmigen Teils (14) eingefüllte Isolierflüssigkeit (8) aufweist.

## Revendications

1. Structure étanche pour élément électrostrictif (9) composé d'une pluralité de feuilles électrostrictives empilées comprenant :
(a) un élément tubulaire (14) logeant ledit élément électrostrictif (9) de façon que la paroi intérieure dudit élément tubulaire soit espacée dudit élément électrostrictif (9),
(b) un premier élément de couvercle (13) fixé à une extrémité dudit élément électrostrictif (9),
(c) un second élément de couvercle (11) fixé à l'extrémité opposée dudit élément électrostrictif (9) présentant des bornes d'électrodes (41, 42) connectées audit élément électrostrictif (9),
(d) lesdits premier et second éléments de couvercle (13, 11) étant combinés audit élément tubulaire (14) de façon flexible et étanche à l'air en utilisant une résine élastique comme moyen d'étanchéité,
caractérisée en ce que
(e) ledit élément électrostrictif (9) est inséré dans ledit élément tubulaire (14) de façon que les surfaces latérales desdits premier et second couvercles (13, 11) soient partiellement couvertes avec l'une respective des parties extrémales dudit élément tubulaire (14), en ce que
(f) chacun des premier et second éléments de couvercle (13, 11) consiste en un disque circulaire de diamètre inférieur au diamètre intérieur dudit élément tubulaire (14) de sorte que les bords latéraux desdits premier et second élements de couvercle (13, 11) sont en contact glissant avec la paroi intérieure dudit élément tubulaire (14) et en ce que
(g) lesdits moyens d'étanchéité (15, 16) rendent étanche l'espace entre la paroi intérieure desdites parties extrémales dudit élément tubulaire (14) et lesdits bords latéraux respectifs desdits premier et second éléments de couvercle (13, 11),
(h) l'épaisseur et le nombre desdites feuilles empilées étant choisis de façon que la valeur du déplacement dudit élément électrostrictif (9) dans une direction de l'axe tubulaire ne dépasse pas la zone de déplacement élastique de la résine élastique desdits moyens d'étanchéité (15, 16) absorbant ledit déplacement sans entraîner de glissement entre lesdits moyens d'étanchéité (15, 16) et ledit élément tubulaire (14).

2. Structure étanche selon la revendication 1, dans laquelle lesdits moyens d'étanchéité consistent en une résine élastique (15) ou un joint torique (16).

3. Structure étanche selon la revendication 2, dans laquelle lesdits premier et second éléments de couvercle (13, 11) présentent une rainure autour de leur partie de bord latéral respectif desdits éléments de couvercle, ladite rainure ayant une profondeur inférieure au diamètre de la section transversale dudit joint torique (16).

4. Structure étanche selon la revendication 1, dans laquelle ledit déplacement dudit élément électrostrictif (9) est d'environ 0,1 mm.

5. Structure étanche selon la revendication 1, dans laquelle lesdits premier et second éléments de couvercle (13, 11) et l'élément tubulaire (14) sont métalliques.

6. Structure étanche selon l'une quelconque des revendications précédentes, comprenant un fluide isolant (8) qui remplit ledit élément tubulaire (14).
